# EUROPEAN PATENT APPLICATION

(11) **EP 4 089 736 A1**
(43) Date of publication of application: **16.11.2022**
(21) Application number: 21744437.1
(22) Date of filing: 19.01.2021
(51) Int. Cl.: H01L 27/148, H04N 5/369, H04N 5/372

(54) **METHOD FOR MANUFACTURING BACK-THINNED SOLID-STATE IMAGING DEVICE**

(30) Priority: 21.01.2020 JP 2020007338
(71) Applicant: Hamamatsu Photonics K.K., Hamamatsu-shi, Shizuoka 435-8558 (JP)
(72) Inventor: YAMAMOTO, Koei, Hamamatsu-shi, Shizuoka 435-8558 (JP); KASUYA, Tatsuki, Hamamatsu-shi, Shizuoka 435-8558 (JP); TANIZAKI, Kazuhiro, Hamamatsu-shi, Shizuoka 435-8558 (JP); SUZUKI, Yoshiyuki, Hamamatsu-shi, Shizuoka 435-8558 (JP)
(74) Representative: Hoffmann Eitle
(86) International application number: PCT/JP2021/001711
(87) International publication number: WO 2021/149686

(57) **Abstract**

A method for manufacturing a back-illuminated solid-state imaging device includes a first step of preparing a first conduction-type semiconductor layer having a front surface and a back surface, a second step of forming a first asperity region on the front surface of the semiconductor layer by selectively etching the front surface of the semiconductor layer, a third step of forming a second asperity region on the front surface of the semiconductor layer by smoothening asperities of the first asperity region, and a fourth step of forming an insulating layer along the second asperity region and forming a plurality of charge transfer electrodes on the insulating layer.

## Description

### Technical Field

The present disclosure relates to a method for manufacturing a back-illuminated solid-state imaging device.

### Background Art

Back-illuminated solid-state imaging devices such as back-illuminated thinning charge coupled devices (BT-CCDs) in which a semiconductor layer is thinned in an imaging unit is known. In such a back-illuminated solid-state imaging device, light incident from a back surface of the semiconductor layer interferes with light reflected by a front surface of the semiconductor layer (that is, an etalon phenomenon occurs), and there is concern that light detecting characteristics may deteriorate.

Patent Literature 1 describes, as a method for manufacturing a back-illuminated solid-state imaging device capable of curbing occurrence of an etalon phenomenon, a method for forming asperities on a front surface of a semiconductor layer by selectively oxidizing a region on the front surface side in the semiconductor layer using a mask and removing the selectively oxidized region through etching.

### Citation List

### Patent Literature

[Patent Literature 1] Japanese Unexamined Patent Publication No. 2010-232494

### Summary of Invention

### Technical Problem

Since the method described in Patent Literature 1 utilizes selective oxidation, in the method, it is difficult to form asperities on the front surface of the semiconductor layer such that distances between projecting portions adjacent to each other (or between recessed portions adjacent to each other) are reduced and heights of the projecting portions (or depths of the recessed portions) increase.

An object of the present disclosure is to provide a method for manufacturing a back-illuminated solid-state imaging device in which a back-illuminated solid-state imaging device capable of curbing occurrence of an etalon phenomenon can be easily and reliably manufactured.

### Solution to Problem

A method for manufacturing a back-illuminated solid-state imaging device according to an aspect of the present disclosure includes a first step of preparing a first conduction-type semiconductor layer having a front surface and a back surface, a second step of forming a first asperity region on the front surface of the semiconductor layer by selectively etching the front surface of the semiconductor layer, a third step of forming a second asperity region on the front surface of the semiconductor layer by smoothening asperities of the first asperity region, and a fourth step of forming an insulating layer along the second asperity region and forming a plurality of charge transfer electrodes on the insulating layer.

In this method for manufacturing a back-illuminated solid-state imaging device, the first asperity region is formed on the front surface of the semiconductor layer by selectively etching the front surface of the semiconductor layer. Accordingly, in consideration of a shape of the second asperity region capable of curbing occurrence of an etalon phenomenon, the first asperity region having a desired shape can be easily and reliably formed. Moreover, the second asperity region is formed on the front surface of the semiconductor layer by smoothening asperities of the first asperity region. Accordingly, in a manufactured back-illuminated solid-state imaging device, it is possible to curb concentration of an electric field in apex portions of projecting portions and bottom portions of recessed portions in the second asperity region, and therefore transfer of charges is allowed to sufficiently function. Thus, according to this method for manufacturing a back-illuminated solid-state imaging device, it is possible to easily and reliably manufacture a back-illuminated solid-state imaging device capable of curbing occurrence of an etalon phenomenon.

In the method for manufacturing a back-illuminated solid-state imaging device according to the aspect of the present disclosure, in the fourth step, a second conduction-type semiconductor region may be formed in the semiconductor layer along the second asperity region. Accordingly, an embedded channel-type CCD can be constituted.

In the method for manufacturing a back-illuminated solid-state imaging device according to the aspect of the present disclosure, in the third step, the asperities of the first asperity region may be smoothened through thermal oxidation and etching. Accordingly, asperities of the first asperity region can be easily and reliably smoothened.

In the method for manufacturing a back-illuminated solid-state imaging device according to the aspect of the present disclosure, in the third step, the asperities of the first asperity region may be smoothened through isotropic etching. Accordingly, asperities of the first asperity region can be easily and reliably smoothened.

The method for manufacturing a back-illuminated solid-state imaging device according to the aspect of the present disclosure may further include a fifth step of attaching a support substrate to parts on the plurality of charge transfer electrodes, a sixth step of thinning the semiconductor layer by polishing the back surface of the semiconductor layer in a state in which the support substrate is attached thereto, and a seventh step of forming an accumulation region in the semiconductor layer along the polished back surface of the semiconductor layer. Accordingly, in a manufactured back-illuminated solid-state imaging device, generation of dark currents due to a defect which has occurred in the back surface of the semiconductor layer can be curbed through polishing.

### Advantageous Effects of Invention

According to the present disclosure, it is possible to provide a method for manufacturing a back-illuminated solid-state imaging device in which a back-illuminated solid-state imaging device capable of curbing occurrence of an etalon phenomenon can be easily and reliably manufactured.

### Brief Description of Drawings

FIG. 1 is a side view of a back-illuminated solid-state imaging device of an embodiment.
FIG. 2 is a plan view of an imaging unit of a back-illuminated solid-state imaging element illustrated in FIG. 1.
FIG. 3 is a cross-sectional view along line III-III illustrated in FIG. 2.
FIG. 4 is a cross-sectional view along line IV-IV illustrated in FIG. 2.
FIG. 5 is a cross-sectional view illustrating a method for manufacturing a back-illuminated solid-state imaging device illustrated in FIG. 1.
FIG. 6 is another cross-sectional view illustrating the method for manufacturing a back-illuminated solid-state imaging device illustrated in FIG. 1.
FIG. 7 is another cross-sectional view illustrating the method for manufacturing a back-illuminated solid-state imaging device illustrated in FIG. 1.
FIG. 8 is another cross-sectional view illustrating the method for manufacturing a back-illuminated solid-state imaging device illustrated in FIG. 1.
FIG. 9 is another cross-sectional view illustrating the method for manufacturing a back-illuminated solid-state imaging device illustrated in FIG. 1.

### Description of Embodiment

Hereinafter, an embodiment of the present disclosure will be described in detail with reference to the drawings. In each of the drawings, the same reference signs are applied to parts which are the same or corresponding, and duplicate description will be omitted.

### [Constitution of back-illuminated solid-state imaging device]

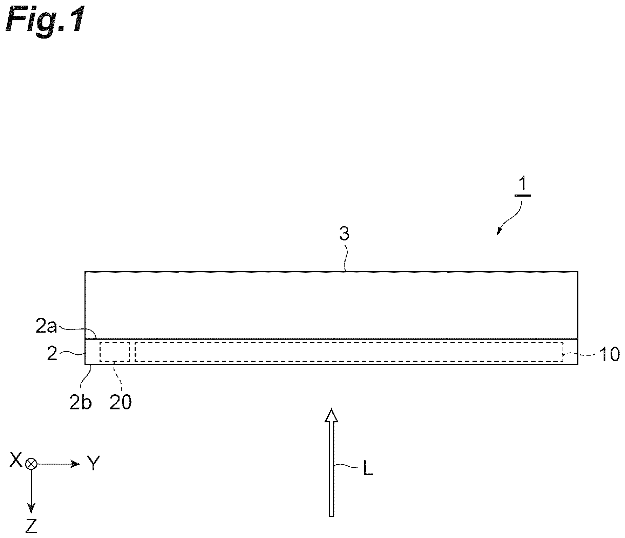

As illustrated in FIG. 1, a back-illuminated solid-state imaging device 1 includes a back-illuminated solid-state imaging element 2 and a support substrate 3. The back-illuminated solid-state imaging element 2 has a front surface 2a and a back surface 2b. As an example, the back-illuminated solid-state imaging element 2 is a BT-CCD for detecting light L incident on the back surface 2b. The support substrate 3 is attached to the front surface 2a of the back-illuminated solid-state imaging element 2 using an adhesive. For example, the support substrate 3 is a glass substrate, a single crystal silicon substrate, or the like. Hereinafter, a direction in which the front surface 2a and the back surface 2b face each other will be referred to as a Z direction, a direction perpendicular to the Z direction will be referred to as an X direction, and a direction perpendicular to the Z direction and the X direction will be referred to as a Y direction.

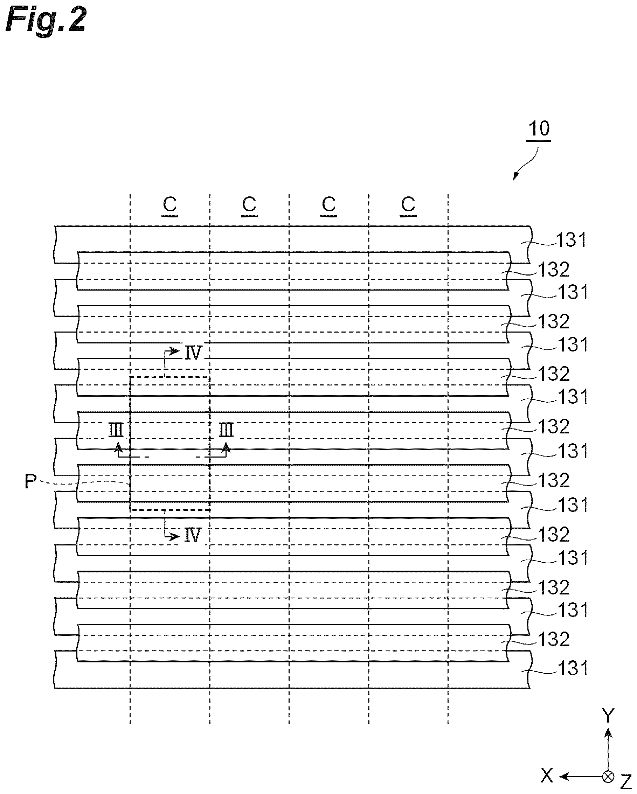

The back-illuminated solid-state imaging element 2 has an imaging unit 10 and a horizontal shift register 20. In the imaging unit 10, a plurality of CCD channels C (refer to FIG. 2) including a plurality of vertical shift registers are constituted. The plurality of CCD channels C are arrayed in the X direction in a state of individually extending in the Y direction. The horizontal shift register 20 is disposed on one side of the imaging unit 10 in the Y direction. When the light L is incident on the imaging unit 10 from the back surface 2b side, charges are generated in the imaging unit 10 due to photoelectric conversion. Charges generated in the imaging unit 10 are sequentially transferred to the horizontal shift register 20 in the Y direction through each of the CCD channels C. The charges transferred to the horizontal shift register 20 are sequentially transferred in the X direction by the horizontal shift register 20 and are output as an image signal from the back-illuminated solid-state imaging element 2.

As illustrated in FIG. 2, the imaging unit 10 has a plurality of charge transfer electrodes 131 and a plurality of charge transfer electrodes 132. Each of the charge transfer electrodes 131 and 132 extends in the X direction such that it intersects the plurality of CCD channels C. The plurality of charge transfer electrodes 131 and the plurality of charge transfer electrodes 132 are alternately arrayed in the Y direction. In the imaging unit 10, pixels P are constituted by regions in which each of the CCD channels C and each of the charge transfer electrodes 131 and 132 intersect each other when viewed in the Z direction (as an example, a region surrounded by a bold dotted line in FIG. 2). Namely, in the imaging unit 10, a plurality of pixels P are arrayed in a matrix shape along a surface perpendicular to the Z direction.

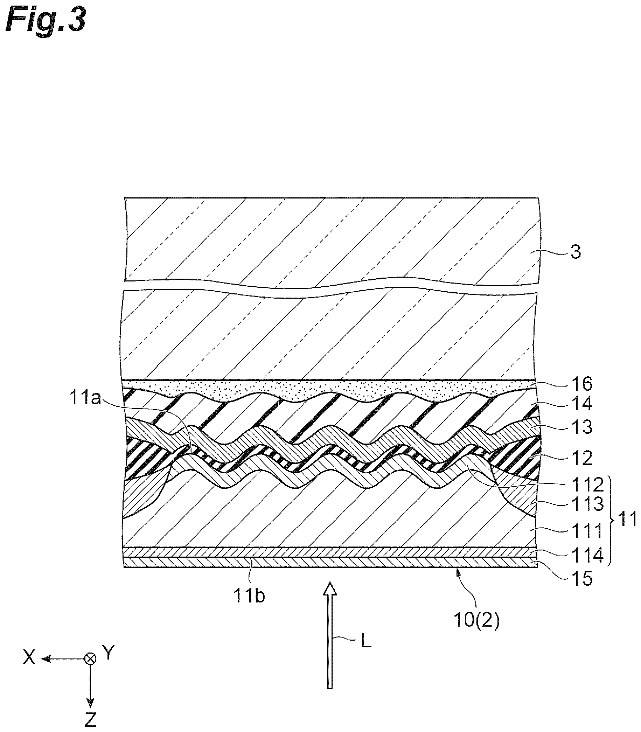

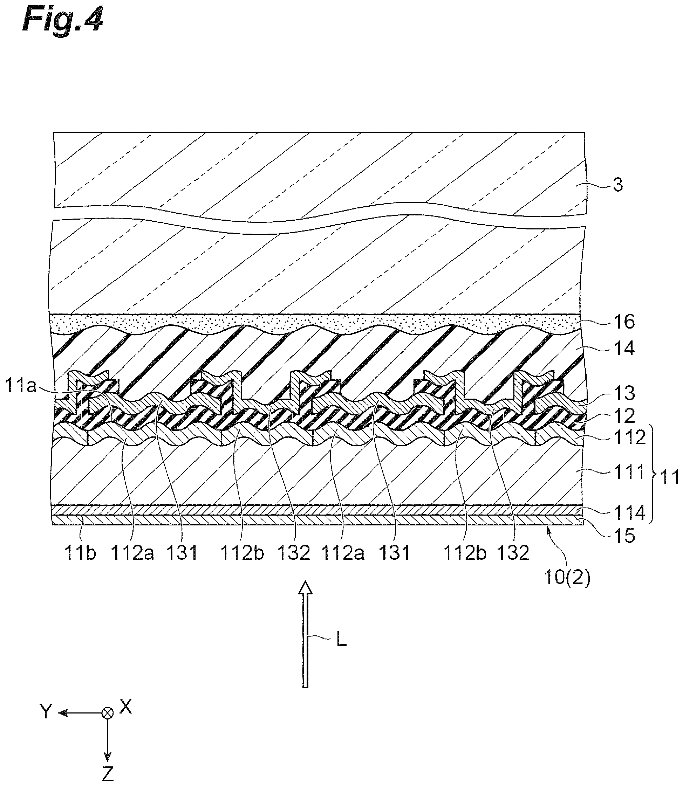

A constitution of the imaging unit 10 of the back-illuminated solid-state imaging element 2 will be described in detail with reference to FIGS. 3 and 4. FIGS. 3 and 4 illustrate a constitution of one pixel P illustrated in FIG. 2. As illustrated in FIGS. 3 and 4, the back-illuminated solid-state imaging element 2 in the imaging unit 10 has a semiconductor layer 11, an insulating layer 12, a plurality of charge transfer electrodes 13 (a generic name of a plurality of charge transfer electrodes 131 and a plurality of charge transfer electrodes 132), a protective layer 14, and an anti-reflective layer 15.

The semiconductor layer 11 has a front surface 11a and a back surface 11b. The front surface 11a is an irregular surface, and the back surface 11b is a flat surface. The semiconductor layer 11 includes a p-type semiconductor region (first conduction-type semiconductor region) 111, a plurality of n-type semiconductor regions (second conduction-type semiconductor regions) 112, a plurality of isolation regions 113, and an accumulation region 114. For example, the semiconductor layer 11 is a layer formed of silicon.

The p-type semiconductor region 111 spreads throughout the imaging unit 10 in its entirety. The plurality of n-type semiconductor regions 112 are positioned on the front surface 11a side with respect to the p-type semiconductor region 111 and are formed along the front surface 11a which is an irregular surface. Each of the n-type semiconductor regions 112 extends in the Y direction for each of the CCD channels C (refer to FIG. 2). Each of the n-type semiconductor regions 112 forms a p-n junction with the p-type semiconductor region 111. Namely, the imaging unit 10 is constituted as an embedded channel-type CCD.

The plurality of isolation regions 113 are positioned on the front surface 11a side with respect to the p-type semiconductor region 111 and are formed along the front surface 11a which is an irregular surface. Each of the isolation regions 113 extends in the Y direction between the n-type semiconductor regions 112 adjacent to each other in the X direction. The accumulation region 114 is positioned on the back surface 11b side with respect to the p-type semiconductor region 111 and is formed along the back surface 11b which is a flat surface. For example, each of the isolation regions 113 and the accumulation region 114 is a region formed of silicon having a higher p-type impurities concentration than the p-type semiconductor region 111.

The insulating layer 12 is formed on the front surface 11a of the semiconductor layer 11 such that the plurality of n-type semiconductor regions 112 and the plurality of isolation regions 113 are covered. For example, the insulating layer 12 is a layer formed of silicon oxide. The plurality of charge transfer electrodes 13 are formed on the insulating layer 12 (more specifically, on a front surface of the insulating layer 12 on a side opposite to the semiconductor layer 11). As an example, both end portions of the charge transfer electrodes 132 in the Y direction are bent such that they are mounted on end portions of the charge transfer electrodes 131 adjacent to each other in the Y direction via the insulating layer 12. For example, each of the charge transfer electrodes 13 is an electrode formed of polysilicon. In each of the n-type semiconductor regions 112, a part 112b other than a part 112a facing each of the charge transfer electrodes 131 has a lower n-type impurities concentration than the part 112a.

The protective layer 14 is formed to cover the insulating layer 12 and the plurality of charge transfer electrodes 13. For example, the protective layer 14 is a layer formed of boro-phospho silicate glass (BPSG). The support substrate 3 is attached to a part on the protective layer 14 (more specifically, on a front surface of the protective layer 14 on a side opposite to the semiconductor layer 11) using an adhesive 16. The anti-reflective layer 15 is formed on the back surface 11b of the semiconductor layer 11 such that the accumulation region 114 is covered. For example, the anti-reflective layer 15 is a dielectric multilayer.

### [Method for manufacturing back-illuminated solid-state imaging device]

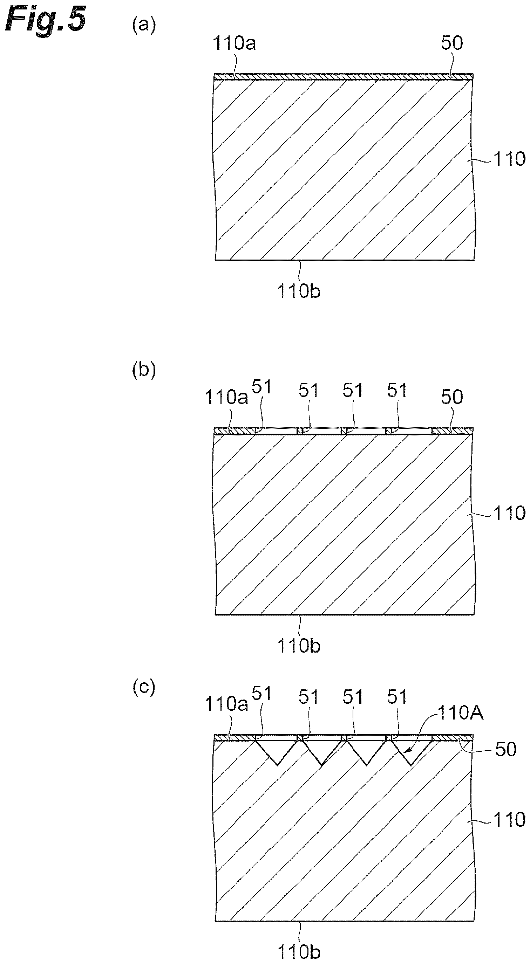

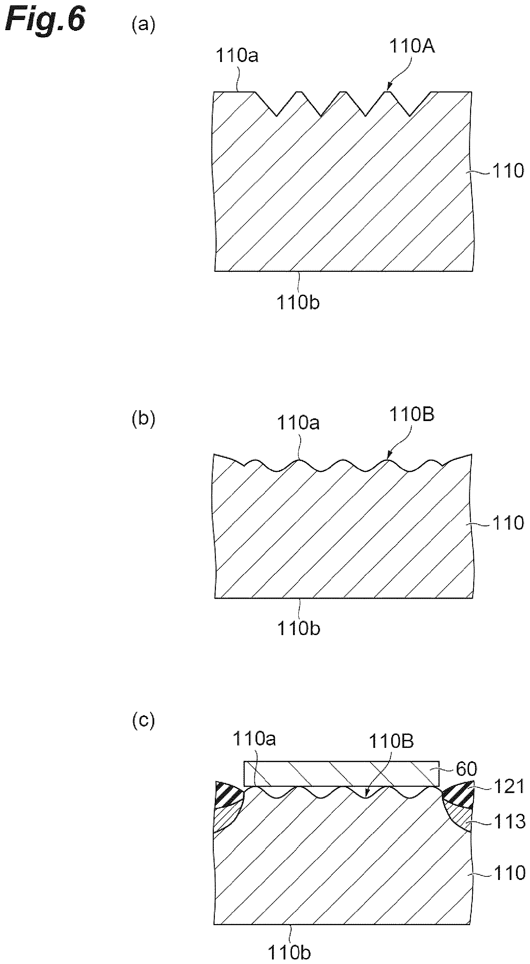

First, as illustrated in (a) of FIG. 5, a p-type semiconductor layer 110 having a front surface 110a and a back surface 11b is prepared (first step). Subsequently, for example, by a sputtering method, for example, a mask 50 formed of silicon nitride is formed on the front surface 110a of the semiconductor layer 110. Subsequently, as illustrated in (b) of FIG. 5, for example, a plurality of openings 51 which are regularly arrayed are formed in the mask 50 through patterning using a photoresist, and parts corresponding to the respective openings 51 on the front surface 110a of the semiconductor layer 110 are exposed. Subsequently, as illustrated in (c) of FIG. 5, a first asperity region 110A is formed on the front surface 110a of the semiconductor layer 110 by selectively etching the front surface 110a of the semiconductor layer 110 (that is, by etching the parts corresponding to the respective openings 51 on the front surface 110a of the semiconductor layer 110) (second step). Subsequently, as illustrated in (a) of FIG. 6, for example, the mask 50 is removed from the front surface 110a of the semiconductor layer 110 through etching using a high temperature phosphoric acid.

In the present embodiment, through anisotropic etching (for example, anisotropic etching using an alkaline etchant), recessed portions having inner surfaces depending on crystal orientation of the semiconductor layer 110 are formed in the parts corresponding to the respective openings 51 on the front surface 110a of the semiconductor layer 110. Namely, the first asperity region 110A is constituted by a plurality of recessed portions formed in such a manner (a plurality of recessed portions which are regularly arrayed). As an example, in the first asperity region 110A, distances between the recessed portions adjacent to each other (distances between the centers thereof) are approximately 800 nm, and a depth of each of the recessed portions is approximately 120 nm.

Subsequently, as illustrated in (b) of FIG. 6, a second asperity region 110B is formed on the front surface 110a of the semiconductor layer 110 by smoothening asperities of the first asperity region 110A through thermal oxidation and etching (third step). More specifically, asperities of the first asperity region 110A are smoothened by forming an oxidation region along the first asperity region 110A through thermal oxidation and removing the oxidation region through etching (for example, wet etching using a fluoric acid or the like). Smoothening asperities of the first asperity region 110A denotes smoothening corner portions (for example, rounding corner portions, such as R-chamfering) formed in at least one of apex portions of projecting portions and bottom portions of recessed portions in the asperities. In the second asperity region 110B, for example, inclination of a tangential line at each point on the second asperity region 110B continuously changes. As an example, in the second asperity region 110B, distances between the recessed portions adjacent to each other (distances between the centers thereof) are approximately 800 nm, and a depth of each of the recessed portions is approximately 100 nm.

Subsequently, as illustrated in (c) of FIG. 6, for example, through patterning using a photoresist, for example, a mask 60 formed of an inorganic material is formed on the front surface 110a of the semiconductor layer 110. In this state, for example, the plurality of isolation regions 113 are formed in the semiconductor layer 110 through ion implantation or diffusion of p-type impurities, and for example, an insulating layer 121 (a part of the insulating layer 12) is formed in the semiconductor layer 110 through thermal oxidation. Formation of the plurality of isolation regions 113 through ion implantation or diffusion of the p-type impurities can be performed after formation of the insulating layer 121 through thermal oxidation.

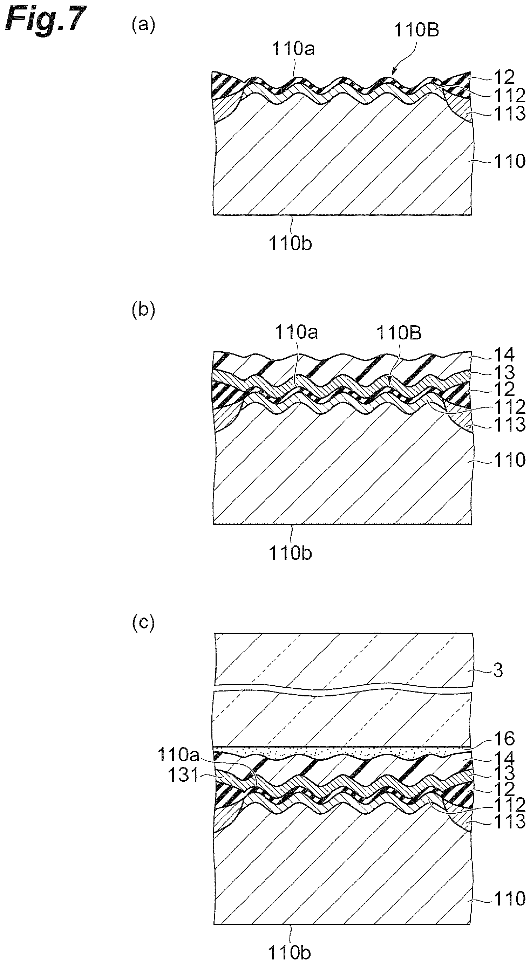

Subsequently, as illustrated in (a) of FIG. 7, the mask 60 is removed from the front surface 110a of the semiconductor layer 110, and for example, the insulating layer 12 is formed along the second asperity region 110B through thermal oxidation (fourth step). Subsequently, for example, the plurality of n-type semiconductor regions 112 are formed in the semiconductor layer 110 along the second asperity region 110B through ion implantation of n-type impurities. Subsequently, as illustrated in (b) of FIG. 7, the plurality of charge transfer electrodes 13 are formed on the insulating layer 12, and the protective layer 14 is formed such that the insulating layer 12 and the plurality of charge transfer electrodes 13 are covered.

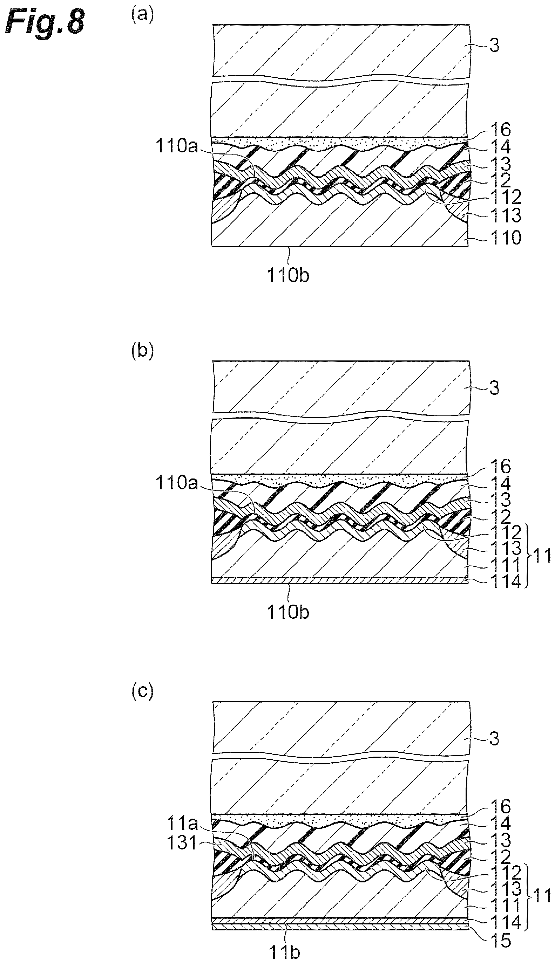

Subsequently, as illustrated in (c) of FIG. 7, the support substrate 3 is attached to a part on the protective layer 14 using the adhesive 16. Namely, the support substrate 3 is attached to parts on the plurality of charge transfer electrodes 13 (fifth step). Subsequently, as illustrated in (a) of FIG. 8, the semiconductor layer 110 is thinned by polishing a back surface 110b of the semiconductor layer 110, for example, through chemical polishing or the like in a state in which the support substrate 3 is attached thereto (sixth step). Subsequently, as illustrated in (b) of FIG. 8, for example, the accumulation region 114 is formed in the semiconductor layer 11 along the polished back surface 110b of the semiconductor layer 110 (that is, the back surface 11b of the semiconductor layer 11) through ion implantation of the p-type impurities (seventh step). Subsequently, as illustrated in (c) of FIG. 8, the anti-reflective layer 15 is formed on the back surface 11b of the semiconductor layer 11 such that the accumulation region 114 is covered.

### [Operations and effects]

In the method for manufacturing the back-illuminated solid-state imaging device 1, the first asperity region 110A is formed on the front surface 110a of the semiconductor layer 110 by selectively etching the front surface 110a of the semiconductor layer 110. Accordingly, in consideration of a shape of the second asperity region 110B capable of curbing occurrence of an etalon phenomenon, the first asperity region 110A having a desired shape can be easily and reliably formed. Moreover, the second asperity region 110B is formed on the front surface 110a of the semiconductor layer 110 by smoothening asperities of the first asperity region 110A. Accordingly, in a manufactured back-illuminated solid-state imaging device 1, it is possible to curb concentration of an electric field in the apex portions of the projecting portions and the bottom portions of the recessed portions in the second asperity region 110B, and therefore transfer of charges is allowed to sufficiently function. Thus, according to the method for manufacturing the back-illuminated solid-state imaging device 1, it is possible to easily and reliably manufacture a back-illuminated solid-state imaging device 1 capable of curbing occurrence of an etalon phenomenon.

In addition, in the method for manufacturing the back-illuminated solid-state imaging device 1, the n-type semiconductor regions 112 are formed in the semiconductor layer 110 along the second asperity region 110B. Accordingly, an embedded channel-type CCD can be constituted.

In addition, in the method for manufacturing the back-illuminated solid-state imaging device 1, asperities of the first asperity region 110A are smoothened through thermal oxidation and etching. Accordingly, asperities of the first asperity region 110A can be easily and reliably smoothened.

In addition, in the method for manufacturing the back-illuminated solid-state imaging device 1, the support substrate 3 is attached to parts on the plurality of charge transfer electrodes 13, the semiconductor layer 110 is thinned by polishing the back surface 110b of the semiconductor layer 110 in this state, and the accumulation region 114 is formed in the semiconductor layer 11 along the polished back surface 110b of the semiconductor layer 110 (that is, the back surface 11b of the semiconductor layer 11). Accordingly, in a manufactured back-illuminated solid-state imaging device 1, generation of dark currents due to a defect which has occurred in the back surface 11b of the semiconductor layer 11 can be curbed through polishing.

### [Modification examples]

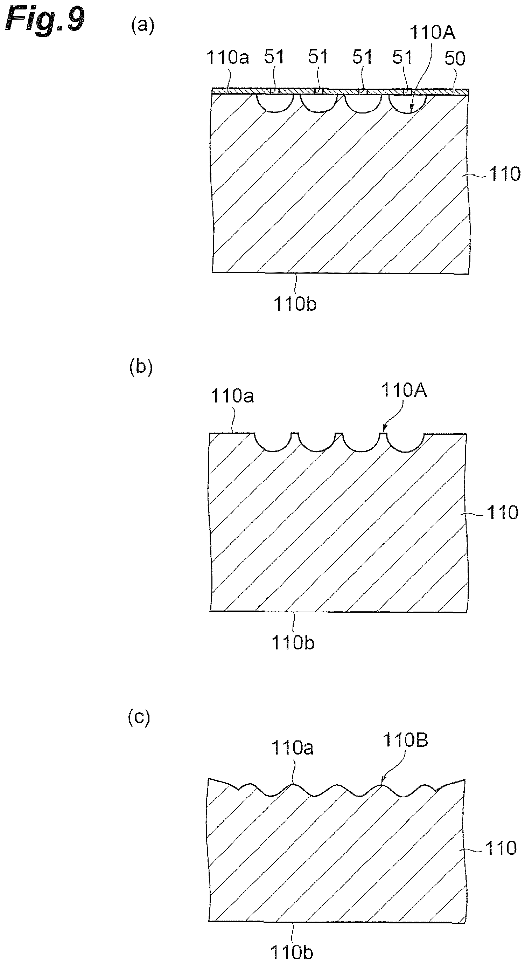

The present disclosure is not limited to the embodiment described above. In the method for manufacturing the back-illuminated solid-state imaging device 1, as illustrated in (a) of FIG. 9, through isotropic etching (for example, isotropic etching using a chemical dry etchant), the recessed portions having inner surfaces not depending on crystal orientation of the semiconductor layer 110 are formed in the parts corresponding to the respective openings 51 on the front surface 110a of the semiconductor layer 110. Accordingly, the first asperity region 110A may be formed on the front surface 110a of the semiconductor layer 110. In this case as well, corner portions are formed in the apex portions of the projecting portions in the asperities of the first asperity region 110A. Hence, as illustrated in (b) of FIG. 9, after the mask 50 is removed from the front surface 110a of the semiconductor layer 110, as illustrated in (c) of FIG. 9, the second asperity region 110B is formed on the front surface 110a of the semiconductor layer 110 by smoothening asperities of the first asperity region 110A.

Etching for forming the first asperity region 110A on the front surface 110a of the semiconductor layer 110 may be either anisotropic etching or isotropic etching and may be either wet etching or dry etching. However, in the case of dry etching, in order to curb occurrence of a defect on the front surface, it is preferable to adopt chemical dry etching.

In addition, in the method for manufacturing the back-illuminated solid-state imaging device 1, the second asperity region 110B may be formed on the front surface 110a of the semiconductor layer 110 by smoothening asperities of the first asperity region 110A through isotropic etching. In this case as well, asperities of the first asperity region 110A can be easily and reliably smoothened. Etching for forming the second asperity region 110B on the front surface 110a of the semiconductor layer 110 (that is, etching for smoothening asperities of the first asperity region 110A) may be either wet etching or dry etching. However, there is a need to adopt isotropic etching.

In addition, in the method for manufacturing the back-illuminated solid-state imaging device 1, formation of a plurality of n-type semiconductor regions 112 may be omitted. Namely, in a manufactured back-illuminated solid-state imaging device 1, the imaging unit 10 may be constituted as a surface channel-type CCD.

In addition, in each of the first asperity region 110A and the second asperity region 110B, asperities may be constituted by a plurality of dot-shaped recessed portions or may be constituted by a plurality of projection-shaped projecting portions. In addition, in each of the first asperity region 110A and the second asperity region 110B, asperities may be constituted by a plurality of groove-shaped recessed portions or may be constituted by a plurality of wall-shaped projecting portions. In the case in which asperities are constituted by a plurality of groove-shaped recessed portions or a plurality of wall-shaped projecting portions, in order to smoothen transfer of charges, it is preferable that each of the recessed portions or each of the projecting portions extend in a direction in which a plurality of charge transfer electrodes 13 are arrayed. In addition, in each of the first asperity region 110A and the second asperity region 110B, asperities may be formed in a regular pattern, or asperities may be formed in an irregular pattern. When asperities are formed in an irregular pattern, a plurality of openings 51 which are irregularly disposed may be formed in the mask 50 for forming the first asperity region 110A.

In addition, for example, when the support substrate 3 is a silicon substrate in which wiring is formed, the back-illuminated solid-state imaging element 2 and the support substrate 3 may be joined to each other (for example, direct bonding) such that an electrode pad of the back-illuminated solid-state imaging element 2 and an electrode pad of the support substrate 3 are electrically connected to each other.

In addition, the conduction types of the p-type and the n-type may be the opposite of that described above. Namely, the first conduction type may be the n-type, and the second conduction type may be the p-type.

### Reference Signs List

1: back-illuminated solid-state imaging device, 3: support substrate, 11, 110: semiconductor layer, 11a, 110a: front surface, 11b, 110b: back surface, 12: insulating layer, 13: charge transfer electrode, 110A: first asperity region, 110B: second asperity region, 112: n-type semiconductor region (semiconductor region of second conduction type), 114: accumulation region.

## Claims

1. A method for manufacturing a back-illuminated solid-state imaging device comprising:
a first step of preparing a first conduction-type semiconductor layer having a front surface and a back surface;
a second step of forming a first asperity region on the front surface of the semiconductor layer by selectively etching the front surface of the semiconductor layer;
a third step of forming a second asperity region on the front surface of the semiconductor layer by smoothening asperities of the first asperity region; and
a fourth step of forming an insulating layer along the second asperity region and forming a plurality of charge transfer electrodes on the insulating layer.

2. The method for manufacturing a back-illuminated solid-state imaging device according to claim 1,
wherein in the fourth step, a second conduction-type semiconductor region is formed in the semiconductor layer along the second asperity region.

3. The method for manufacturing a back-illuminated solid-state imaging device according to claim 1 or 2,
wherein in the third step, the asperities of the first asperity region are smoothened through thermal oxidation and etching.

4. The method for manufacturing a back-illuminated solid-state imaging device according to claim 1 or 2,
wherein in the third step, the asperities of the first asperity region are smoothened through isotropic etching.

5. The method for manufacturing a back-illuminated solid-state imaging device according to any one of claims 1 to 4 further comprising:
a fifth step of attaching a support substrate to parts on the plurality of charge transfer electrodes;
a sixth step of thinning the semiconductor layer by polishing the back surface of the semiconductor layer in a state in which the support substrate is attached thereto; and
a seventh step of forming an accumulation region in the semiconductor layer along the polished back surface of the semiconductor layer.
